# EUROPEAN PATENT APPLICATION

(11) **EP 1 895 822 A1**
(43) Date of publication of application: **05.03.2008**
(21) Application number: 07113811.9
(22) Date of filing: 03.08.2007
(51) Int. Cl.: H05K 7/14

(54) **A disposition for fastening and holding plane elements on a support**

(30) Priority: 31.08.2006 FR 0653517
(71) Applicant: Alcatel Lucent, 75008 Paris (FR)
(72) Inventor: Laizet, Lionel, 44160, PONTCHATEAU (FR); Dumas, Lionnel, 44600, SAINT-NAZAIRE (FR); Le Bayon, Armel, 44600, SAINT NAZAIRE (FR)
(74) Representative: Sciaux, Edmond

(57) **Abstract**

The present invention relates to a device for fastening and holding plane elements, the device comprising in combination an elongate strip forming a support for the plane element, at least one clip including fastener means for fastening to the strip and engagement means for engaging in the plane element, at least one abutment placed at the end of the strip, the abutment including fastener means for fastening to the strip and connection means for connection to the plane element. The invention also provides a method of fastening a plane element by means of said device and comprising the following steps: fastening the abutment to the end of the strip and engaging the plane element in the clips, then fastening the strip carrying the plane element in the strip, and finally connecting the plane element to the abutment.

## Description

The present invention relates to a device for rapidly fastening and holding plane elements that are disposed perpendicularly to the surface of a strip in such a manner as to prevent any relative movement between a plane element and the strip. The invention is suitable for use in particular for fastening a printed circuit plate on an elongate support.

The device of the invention is particularly intended for antennas comprising a carrier structure of elongate shape. Rows of individual radiating dipoles separated by screens are placed along the structure and connected to a feeder cable. The antennas are generally placed in open air and are subjected to weathering. It is therefore essential for the radiating elements they contain to be securely fastened and held so as to withstand the shocks and/or vibrations that might occur. Nevertheless, in order to make antenna fabrication less expensive, the plane elements carrying the radiating dipoles must be capable of being put into place quickly and easily using means that are inexpensive.

The prior art discloses fastener systems for plane elements such as printed circuits.

Document EP-0 542 163 describes an anti-shock and anti-vibration device for fastening printed circuit plates to a support that includes grooves, with fastening being by means of a self-locking clamping device comprising a rail provided with a pin that co-operates with a slot carried by a compression strap, that device does not enable plates to be put into place quickly.

Devices are known that enable a printed circuit card to be withdrawn and put into place quickly by sliding in a groove in an elongate support. Such devices do not prevent the card from moving longitudinally.

Devices are also known that are provided with abutments, possibly including fastener means for fastening the plane elements to the abutments. Such a device does not enable a plane element of great length to be held suitably. In particular, for an outdoor application that is subjected to hazards in the environment, in particular due to weather such as a storm, those devices are not capable of performing their holding function.

An object of the present invention is to eliminate the drawbacks of the prior art by proposing a device for quickly fastening a plane element on a support, the device comprising a combination of a small number of parts, the parts being simple in shape and being made of material that is inexpensive, enabling plane elements to be fastened easily and quickly while ensuring that they are held regardless of the surrounding conditions.

The present invention provides a device for fastening and holding a plane element, the device comprising an elongate strip supporting the plane element and at least one abutment placed at each end of the strip and including fastener means for fastening to the strip and locking means co-operating with a notch formed in the plane element, the device being characterized in that the abutments further include connection means co-operating with a tab of the plane element, and in that the device further includes at least one clip placed between the abutment and independent of the strip, the clip comprising fastener means for fastening to the strip and engagement means for engaging in an orifice of the plane element by tilting, so as to prevent any displacement of the plane element relative to the strip.

In a first embodiment of the invention, the fastener means for fastening to the strip comprise a foot in the shape of an anchor suitable for co-operating with a notch formed in the strip.

In a second embodiment of the invention, the engagement means of the clip received in the plane element comprises a first portion in relief suitable for co-operating with a hole formed in the plane element, and a second portion in relief extending perpendicularly to the first portion in relief to form a housing into which the plane element is inserted.

In a third embodiment of the invention, the fastener means for fastening the plane elements to the abutment include an orifice carried by the abutment suitable for co-operating with a tab projecting from the end of the plane element.

Preferably, the clips and the abutments are made of a plastics material presenting a certain degree of flexibility, such as a polypropylene, for example.

Also preferably, the strip is made of a plastics material presenting a certain degree of rigidity, such as a polycarbonate, for example.

The present invention also provides a method of fastening a plane element by means of a device comprising an elongate strip, at least one abutment at each end of the strip including fastener means for fastening to the strip, locking means co-operating with a notch formed in the plane element and connection means co-operating with a tab of the plane element, and at least one clip comprising fastener means for fastening to the strip and engagement means for engaging in an orifice of the plane element, the method being characterized in that it comprises the following steps:
· fastening the abutment to the end of the strip;
· engaging the plane element in the clips;
· fastening the strip carrying the plane element in the clips; and
· connecting the plane element to the abutment.

In a first implementation of the invention, the plane element is inserted in a housing formed by first and second portions in relief of the clip, which portions are oriented perpendicularly to each other, after which the plane element is tilted so as to insert the first portion in relief of the clip into a hole pierced in the plane element.

In a second implementation of the invention, the clips carrying the plane element are inserted in the strip in such a manner that the feet of the clips penetrate into the notches of the strip.

In a third implementation of the invention, the plane element is connected to the abutment by inserting the tab projecting from the end of the plane element in an orifice in the abutment.

The present invention also provides an antenna including a device as described above. The plane elements comprise printed circuits forming rows of dipoles and metallic screens. The circuits and the screens are disposed in parallel and in alternation, and they are fastened and held by the device of the invention.

Other characteristics and advantages of the present invention appear on reading the following description of an embodiment, naturally given by way of non-limiting illustration, and from the accompanying drawings, in which:
· Figure 1 is a fragmentary perspective view of an antenna including the device of the present invention;
· Figures 2A and 2B show an embodiment of the strip of the device of the invention;
· Figure 3 shows an embodiment of the clip of the device of the invention;
· Figure 4 shows an embodiment of the abutment of the device of the invention;
· Figure 5 shows an example of an end of the plane element suitable for co-operating with the abutment of Figure 4; and
· Figure 6 is a fragmentary perspective view on a larger scale showing an antenna including the device of the present invention.

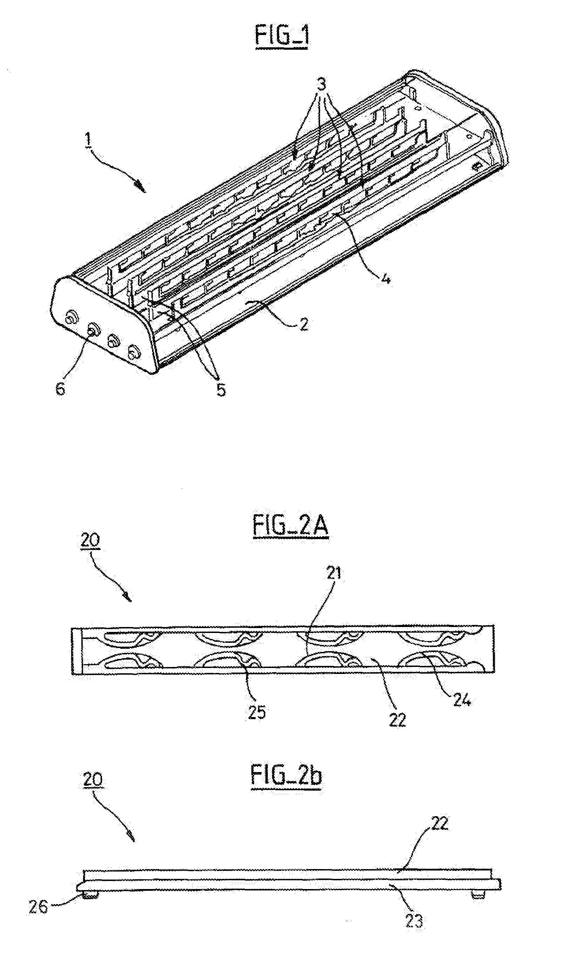

In the embodiment of the invention shown in Figure 1, the antenna 1 comprises a frame 2 having profiled longitudinal strips secured thereto carrying parallel printed circuit plates 3 carrying rows of unit dipoles 4 that are separated by flat metallic screens 5. The dipoles are fed via connectors 6.

Figure 2A shows a strip 20 seen from above, and Figure 2B shows the same strip 20 seen in profile. The strip 20 has a first series of circularly-arcuate notches 21 formed in its top portion 22 for receiving the bases of clips. In the bottom portion 23 there is disposed a second series of notches 24 in register with the notches 21 of the first series. These notches 24 include respective portions in relief 25 forming springs in order to retain the clips once inserted. The strip 20 possesses feet 26.

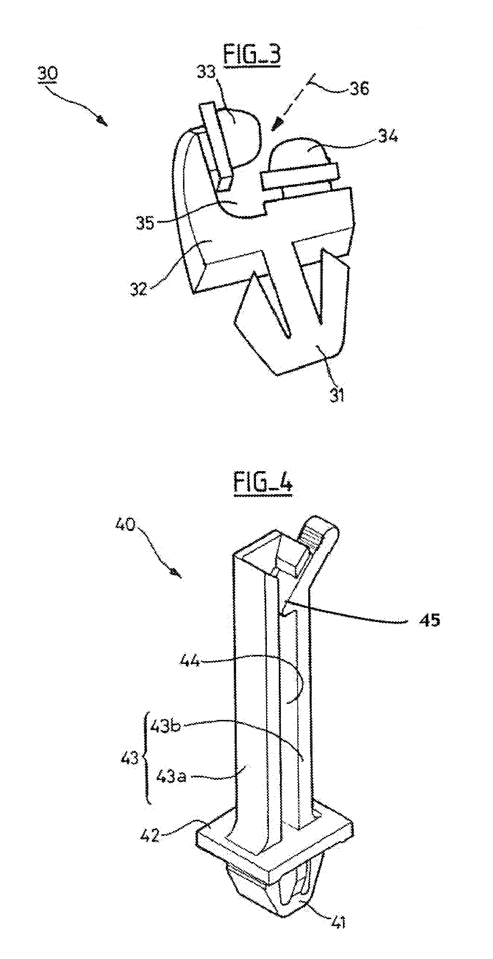

Figure 3 shows an embodiment of a clip 30. The clip 30 has a foot 31 shaped like an anchor with flexible branches, for co-operating with the matching notches 21, 24 formed in the strip 20. The foot 31 supports a base 32 carrying a first portion in relief 33 and a second portion in relief 34 extending perpendicularly to each other so as to form a housing 35 in which the bottom edge of a plane element 3, 5 can be inserted. The plane element 3, 5 is inserted between the portions in relief 33 and 34 in the direction represented by arrow 36, and is then tilted so as to insert the first portion in relief 33 into a hole provided in the element 3, 5 so as to lock the plane elements 3, 5.

Figure 4 shows an embodiment of an end abutment 40. The abutment 40 has a foot 41 shaped like an anchor with flexible branches, that is to co-operate with matching notches 21, 24 formed in the strip 20. The foot 41 supports a base 42 surmounted by a projection 43 having a top portion that includes two branches 43a, 43b that are spaced apart a little so as to form a slot 44 in which the plane elements 3, 5 can be inserted.

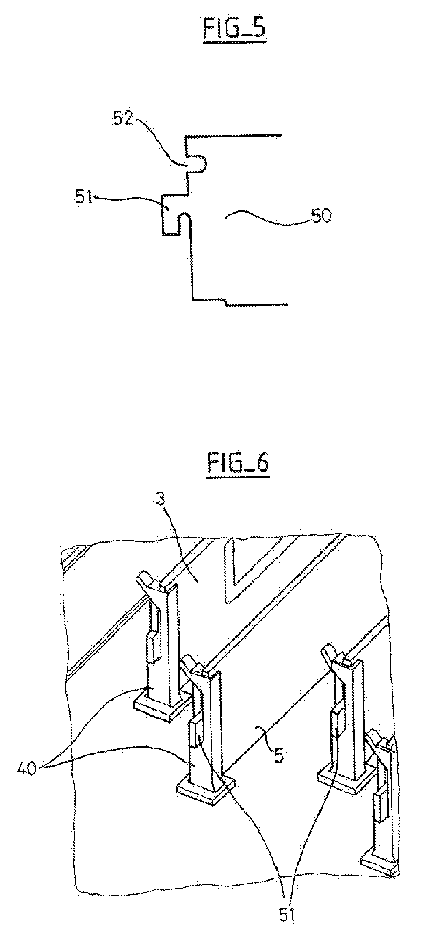

Figure 5 shows the shape of the end 50 of the plane element 3, 5 having a projecting tab 51 for co-operating with the orifice 44 of the abutment 40. The end 50 includes a notch 52 that makes it easier to position the tab 51 relative to the abutment 40 and that enables the plane element to be locked by inserting a stud 45 of the abutment into the notch 52.

Figure 6 is a perspective view showing the abutment 40 in place, secured to the strip 20, in which abutment there is inserted the tab 51 placed at the end 50 of the plane element 3, 5.

It will be understood that by the combined action of the abutment 40 and of the clips 30 secured to and interconnected by the strip 20, the plane elements 3 or 5 are held in self-locking manner and are capable of withstanding shock and vibration at high intensity.

## Claims

1. A device for fastening and holding a plane element (3, 5), the device comprising an elongate strip (20) supporting the plane element (3, 5, 50) and at least one abutment (40) placed at each end of the strip (20) and including fastener means (41) for fastening to the strip (20) and locking means (45) co-operating with a notch (52) formed in the plane element (3, 5), the device being **characterized in that** the abutments (40) further include connection means (43, 44) co-operating with a tab (51) of the plane element (3, 5), and **in that** the device further includes at least one clip (30) placed between the abutment (40) and independent of the strip (20), the clip comprising fastener means (31) for fastening to the strip (20) and engagement means (33, 34, 35) for engaging in an orifice of the plane element (3, 5) by tilting, so as to prevent any displacement of the plane element (3, 5) relative to the strip (20).

2. A device according to claim 1, in which the fastener means for fastening to the strip (20) comprise a foot (31, 41) in the shape of an anchor suitable for co-operating with a notch (21, 24) formed in the strip (20).

3. A device according to claim 1, in which the engagement means of the clip (30) received in the plane element (3, 5) comprise a first portion (33) in relief suitable for co-operating with a hole formed in the plane element (3, 5), and a second portion in relief (34) extending perpendicularly to the first portion in relief (33) to form a housing into which the plane element (3, 5) is inserted.

4. A device according to claim 1, in which the fastener means for fastening the plane elements (3, 5) to the abutment (40) include an orifice (44) carried by the abutment (40) suitable for co-operating with a tab (51) projecting from the end of the plane element (3, 5).

5. A device according to any one of claims 1 to 4, in which the clips (30) and the abutments (40) are made of polypropylene.

6. A device according to any one of claims 1 to 4, in which the strip (20) is made of polycarbonate.

7. A method of fastening a plane element (3, 5) by means of a device comprising an elongate strip (20), at least one abutment (40) at each end of the strip (20) including fastener means (41) for fastening to the strip (20), locking means (45) co-operating with a notch (52) formed in the plane element (3, 5) and connection means (43, 44) co-operating with a tab (51) of the plane element (3, 5), and at least one clip (30) comprising fastener means (31) for fastening to the strip (20) and engagement means (33, 34, 35) for engaging in an orifice of the plane element (3, 5), the method being **characterized in that** it comprises the following steps:
· fastening the abutment (40) to the end of the strip (20);
· engaging the plane element (3, 5) in the clips (30);
· fastening the strip (20) carrying the plane element (3, 5) in the clips (30); and
· connecting the plane element (3, 5) to the abutment.

8. A method according to claim 7, in which the plane element (3, 5) is inserted in a housing (35) formed by first and second portion (33; 34) in relief of the clip (30), which portions are oriented perpendicularly to each other, after which the plane element (3, 5) is tilted so as to insert the first portion (33) in relief of the clip (30) into a hole pierced in the plane element (3, 5).

9. A method according to claim 7, in which the clips (30) carrying the plane element (3, 5) are inserted in the strip (20) in such a manner that the feet (31) of the clips (30) penetrate into the notches (21, 24) of the strip (20).

10. A method according to claim 7, in which the plane element (3, 5) is connected to the abutment (40) by inserting the tab (51) projecting from the end (50) of the plane element (3, 5) in an orifice (44) in the abutment (40).

11. An antenna comprising a device according to any one of claims 1 to 4, **characterized in that** the plane elements (3, 5) comprise printed circuits (3) forming rows of dipoles (4), and metal screens (5), the circuits (3) and the screens (5) being disposed in parallel and in alternation.
